# EUROPEAN PATENT APPLICATION

(11) **EP 4 807 988 A1**
(43) Date of publication of application: **16.09.2026**
(21) Application number: 24910605.5
(22) Date of filing: 05.12.2024
(51) Int. Cl.: H03H 9/10, H03H 9/54, H03H 9/64

(54) **FILTER PACKAGING STRUCTURE AND MANUFACTURING METHOD THEREFOR**

(30) Priority: 29.12.2023 CN 202311854835
(71) Applicant: Vanchip (Tianjin) Technology Co. Ltd, Tianjin 300457 (CN)
(72) Inventor: SU, Xiaoyu, Tianjin 300457 (CN)
(74) Representative: Patentship Patentanwaltsgesellschaft mbH
(86) International application number: PCT/CN2024/136958
(87) International publication number: WO 2025/139673

(57) **Abstract**

The present invention provides a manufacturing method for a filter packaging structure, which includes: providing a carrier formed, on a surface thereof, with a roof structure including a roof attached to the surface of the carrier and a support wall on the roof; providing a substrate formed, on a surface thereof, with a resonant structure including a resonance body and electrodes on opposite sides of the resonance body, each having a first portion adjacent to the resonance body and a second portion away from the resonance body; bonding the carrier and the substrate to each other so that the support wall is bonded to the first portions of the electrodes and that the substrate, the support wall and the roof together enclose a cavity necessary for operation of the resonance body; removing the carrier, thereby exposing the second portions of the electrodes; and forming conductive structures on the second portions of the electrodes. This circumvents the formation of a cavity by laminating a film onto the support wall, allowing the filter packaging structure to have high reliability and a reduced thickness. The present invention also provides a filter packaging structure.

## Description

### TECHNICAL FIELD

The present invention relates to the field of packaging technology, and more particularly to a filter packaging structure and a method of manufacturing it.

### BACKGROUND

As an important component of a radio frequency (RF) front-end, a surface acoustic wave (SAW) filter operates based on the propagation of acoustic waves along the surface of an associated chip. Accordingly, the packaging of a SAW filter is required to ensure that the surface of an interdigital transducer (IDT) therein is not in contact with anything else. That is, a sufficient space must be reserved for operation of the IDT.

Traditionally, a SAW filter chip is first subjected to primary packaging for forming a cavity necessary for operation of an IDT therein, which may be accomplished by chip-size packaging (CSP), wafer-level packaging (WLP) or another packaging technique. Subsequently, the packaging structure obtained from the primary packaging is further subjected to secondary packaging for integrating the packaging structure into a module. A conventional method for primary packaging includes: forming a support wall on the surface of a substrate formed with the IDT thereon; laminating a film, as a roof, onto the support wall, thereby forming the cavity necessary for operation of the IDT; and forming solder pads above the roof and bumps on the solder pads, which serve for external connection of electrodes beside the IDT.

However, in the above described conventional method for primary packaging, the roof laminated on the support wall tends to lack flatness, uniformity and adhesion strength. As a consequence, in the process of secondary packaging, in which an increased pressure is used, the cavity formed in the packaging structure from the primary packaging is prone to deformation, and the roof is prone to peeling, or even caving into the cavity in severe cases, under the action of the higher pressure. These would affect IDT operation and lead to poor reliability of the packaging structure. Further, since external connection of the electrodes is accomplished by the solder pads formed above the roof and the bumps formed on the solder pads in the conventional method, the resulting packaging structure has an undesired large thickness.

### SUMMARY

It is an object of the present invention to provide a filter packaging structure with a reduced thickness and higher reliability and a method of manufacturing such a filter packaging structure.

To this end, in one aspect of the present invention, there is provided a method of manufacturing a filter packaging structure, which includes: providing a carrier formed, on a surface thereof, with a roof structure including a roof attached to the surface of the carrier and a support wall on the roof; providing a substrate formed, on a surface thereof, with a resonant structure including a resonance body and electrodes on opposite sides of the resonance body, each having a first portion adjacent to the resonance body and a second portion away from the resonance body; bonding the carrier formed with the roof structure on its surface and the substrate formed with the resonant structure on its surface to each other so that the support wall is bonded to the first portions of the electrodes and that the substrate, the support wall and the roof together enclose a cavity necessary for operation of the resonance body; removing the carrier, thereby exposing the second portions of the electrodes that extend laterally beyond the roof structure; and forming conductive structures on the second portions of the electrodes, which protrude beyond a surface of the roof away from the resonant structure.

Optionally, providing the carrier formed with the roof structure on its surface may include: providing the carrier; forming a first material layer over the surface of the carrier; performing a patterning treatment on the first material layer to form the roof; forming a second material layer over the surface of the carrier, which covers the roof; and performing a patterning treatment on the second material layer to form the support wall.

Optionally, each of the roof and the support wall may be made of a material including a photoresist material, wherein the performing a patterning treatment on of the first material layer and the performing a patterning treatment on of the second material layer each include an exposure and development process.

Optionally, after the first material layer is patterned to form the roof and before the second material layer is formed over the surface of the carrier, a circuit pattern may be formed on the roof.

Optionally, before the first material layer is formed over the surface of the carrier, an inorganic material layer may be formed on the surface of the carrier and patterned to form a reinforcement layer, wherein the roof resides on the reinforcement layer.

Optionally, the resonance body may be an interdigital transducer (IDT), wherein providing the substrate formed with the resonant structure on its surface includes: providing the substrate; forming a metallic material layer on the surface of the substrate; and performing a patterning treatment on the metallic material layer to form the IDT and the electrodes that are attached to the surface of the substrate.

Optionally, forming the conductive structures on the second portions of the electrodes may include: forming conductive posts on the second portions of the electrodes; and forming bumps at ends of the conductive posts away from the electrodes, which extend beyond the surface of the roof away from the resonant structure.

In another aspect of the present invention, there is provided filter packaging structure including a substrate, a resonant structure, a roof structure and conductive structures. The resonant structure is formed on a surface of the substrate and includes a resonance body and electrodes on opposite sides of the resonance body, each having a first portion adjacent to the resonance body and a second portion away from the resonance body. The roof structure includes a roof and a support wall on the roof. The support wall is bonded to the first portions of the electrodes, with the second portions of the electrodes extending laterally beyond the roof structure. The support wall, the roof and the substrate together enclose a cavity necessary for operation of the resonance body. The conductive structures are arranged on the second portions of the respective electrodes and protrude beyond a surface of the roof away from the resonant structure.

Optionally, the resonance body may be an interdigital transducer (IDT), wherein the electrodes are located on opposite sides of the IDT.

Optionally, the support wall may surround the resonance body.

Optionally, the roof may be formed with a circuit pattern on its surface adjacent to the resonance body.

Optionally, the roof structure may further include a reinforcement layer attached to the surface of the roof away from the resonant structure.

Optionally, each of the conductive structures may include a conductive post and a bump, the conductive post attached at one end to the second portion of a respective one of the electrodes, the bump provided at the other end of the conductive post away from the respective electrode and protruding beyond the surface of the roof away from the resonant structure.

Optionally, each of the support wall and the roof may be made of a photoresist material.

The present invention provides a filter packaging structure and a method of manufacturing the structure, in which a roof structure may be fabricated on a carrier in advance and bonded to a substrate formed with a resonant structure on its surface by bonding a support wall therein to electrodes in the resonant structure, resulting in the formation of a cavity necessary for operation of a resonance body. This circumvents the formation of a cavity by laminating a film onto the support wall, which may suffer from poor flatness, uniformity and adhesion strength of the laminated film, and hence from proneness of the cavity to deformation and of the roof to peeling, improving reliability of the filter packaging structure. Moreover, compared with forming a cavity using a cap wafer, this entails a low-cost process with reduced control complexity and allows the resulting packaging structure to have a smaller thickness. According to the present invention, the support wall is bonded to first portions of the electrodes, with second portions thereof extending laterally beyond the roof structure being reserved. Thus, after the roof structure is bonded to the substrate, conductive structures can be directly formed on the second portions of the electrodes without perforation, entailing a simple process. Moreover, compared with forming solder pads and bumps on the roof, directly forming the conductive structures on the second portions of the electrodes enables easier control of a height of the conductive structures protruding beyond the roof, contributing to a reduced thickness of the resulting filter packaging structure.

### BRIEF DESCRIPTION OF THE DRAWINGS

Fig. 1 shows a flowchart of a method of manufacturing a filter packaging structure according to an embodiment of the present invention.
Figs. 2 to 10 show schematic diagrams illustrating steps in a method of manufacturing a filter packaging structure according to an embodiment of the present invention.
Fig. 11 shows a schematic cross-sectional view of a filter packaging structure according to an embodiment of the present invention.
Fig. 12 shows a schematic cross-sectional view of a filter packaging structure according to another embodiment of the present invention.

In these figures, 101 denotes a carrier; 102, an adhesive layer; 103a, a first material layer; 103, a roof; 104, a circuit pattern; 105, a support wall; 106 a reinforcement layer; 201 a substrate; 202 a resonance body; 203 an electrode; 203a a second portion of an electrode; 301 a cavity; 302 a conductive post; and 303 a bump.

### DETAILED DESCRIPTION

The present invention will be described in greater detail below with reference to the accompanying drawings, which illustrate specific embodiments thereof. From the following description, advantages and features of the present invention will become more apparent. Note that the figures are provided in a very simplified form not necessarily drawn to exact scale for the only purpose of facilitating easy and clear description of the embodiments disclosed herein.

The present invention seeks to provide a filter packaging structure with a reduced thickness and higher reliability and a method of manufacturing such a filter packaging structure.

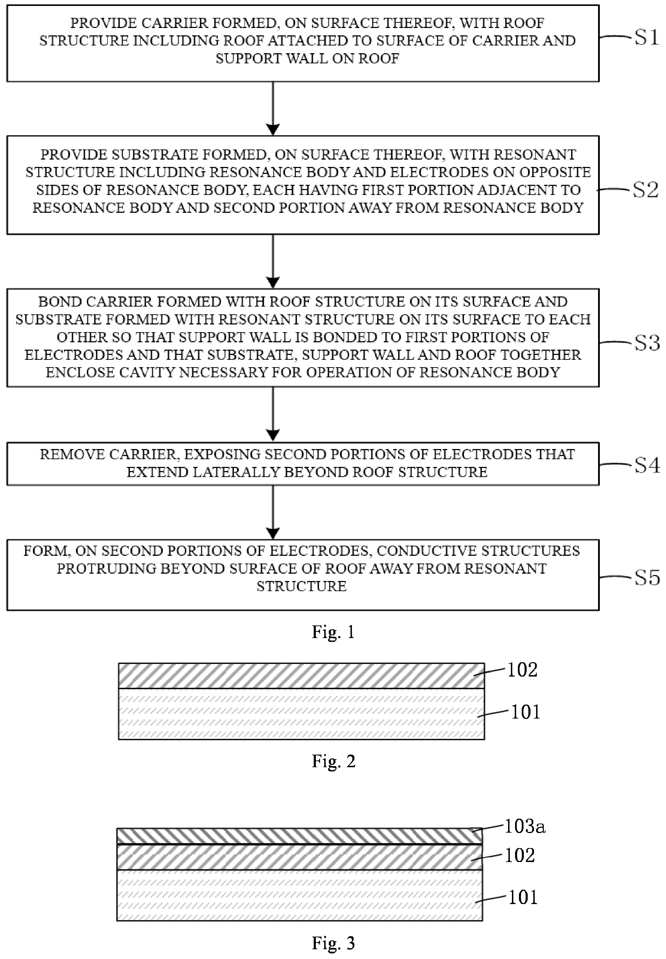

Fig. 1 shows a flowchart of a method of manufacturing a filter packaging structure according to an embodiment of the present invention. As shown in Fig. 1, a method of manufacturing a filter packaging structure according to an embodiment of the present invention includes the steps of:
S1) providing a carrier formed, on a surface thereof, with a roof structure including a roof attached to the surface of the carrier and a support wall on the roof;
S2) providing a substrate formed, on a surface thereof, with a resonant structure including a resonance body and electrodes on opposite sides of the resonance body, each having a first portion adjacent to the resonance body and a second portion away from the resonance body;
S3) bonding the carrier and the substrate so that the support wall is bonded to the first portions of the electrodes and that substrate, the support wall and the roof together enclose a cavity necessary for operation of the resonance body;
S4) removing the carrier, thereby exposing the second portions of the electrodes that extend laterally beyond the roof structure; and
S5) forming conductive structures on the second portions of the electrodes, which protrude beyond a surface of the roof away from the resonant structure.

It is to be understood that although the steps in the flowchart of Fig. 1 are shown in sequential order as indicated by the arrows, they are not necessarily performed in that order. Unless otherwise specified herein, these steps are not limited to being performed strictly in any particular order and may be performed in any other suitable order than that shown in the figure. Moreover, at least some of the steps in the flowchart of Fig. 1 may include multiple sub-steps or phases, which are not necessarily performed at the same time and may be performed at different times. In addition, these sub-steps or phases are not necessarily performed in any particular order. Rather, they may be performed alternately with other steps or at least some sub-steps or phases thereof.

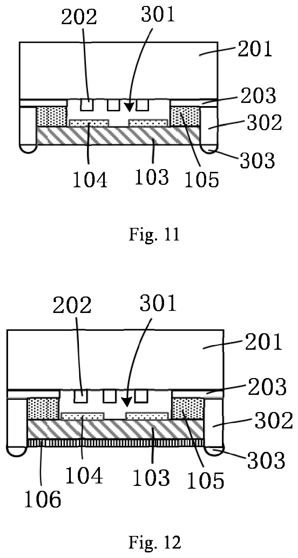

Figs. 2 to 10 show schematic diagrams illustrating steps in a method of manufacturing a filter packaging structure according to an embodiment of the present invention. Fig. 11 shows a schematic cross-sectional view of a filter packaging structure according to an embodiment of the present invention. A method of manufacturing a filter packaging structure according to an embodiment of the present invention will be described below with reference to Figs. 1 to 11.

In step S1, as shown in Figs. 2 to 5, a carrier 101 formed with a roof structure on a surface thereof is provided. The roof structure includes a roof 103 attached to the surface of the carrier 101 and a support wall 105 on the roof 103.

Specifically, as shown in Fig. 2, the carrier 101 may be provided, the carrier 101 is a rigid carrier, such as a wafer or glass plate. An adhesive layer 102 may be applied to the surface of the carrier 101 in order to facilitate attachment of the roof structure to the carrier 101 and its subsequent detachment from the carrier 101. In the present embodiment, the carrier 101 can be repeatedly recycled and reused, resulting in cost savings.

For example, in the case of the adhesive layer 102 being designed to be detached from the carrier 101 and from the roof 103 using a laser beam, the carrier 101 is desired to be chosen as a transparent carrier, such as a glass plate. The adhesive layer 102 may be applied by pressing, adhesive bonding, spin coating or otherwise.

As shown in Fig. 3, a first material layer 103a may be formed over the surface of the carrier 101, the first material layer 103a covers the carrier 101 and the adhesive layer 102.

As a non-limiting example, suitable materials for the first material layer 103a may include photoresist materials, such as polyimide (PI), benzocyclobutene (BCB) and other polymers. Such a photoresist material may be provided either in the form of a dry film, or as a liquid, which may be coated on the carrier 101 and then cured into the first material layer 103a.

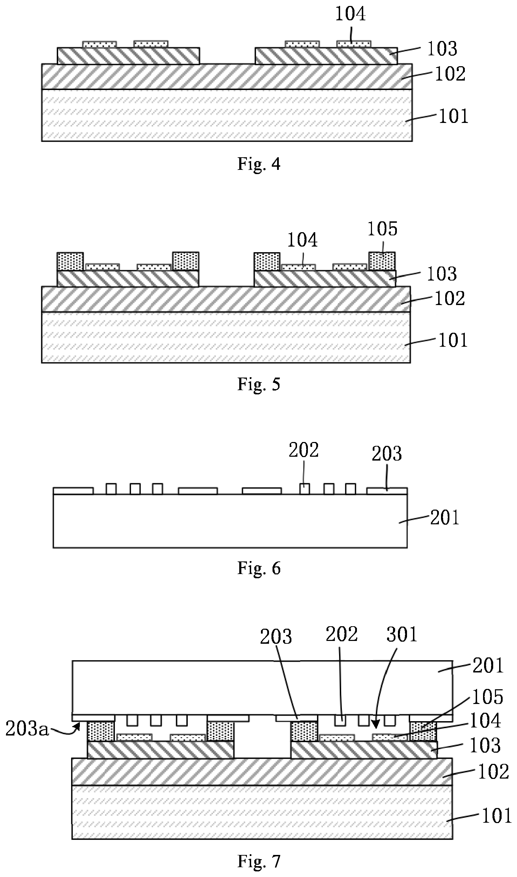

As shown in Fig. 4, the first material layer 103a may be patterned to form the roof 103. In the case of the first material layer 103a being a photoresist material, as an example, the performing a patterning treatment on of the first material layer 103a may involve an exposure and development process thereon. This allows the roof 103 to be formed with high dimensional accuracy using a simple process. In an alternative embodiment, after the first material layer 103a is formed, a patterned mask layer may be formed thereon, and the first material layer 103a may be then etched while being protected by the patterned mask layer, thereby obtaining the roof 103.

As shown in Fig. 4, the first material layer 103a over the carrier 101 may be patterned to form more than one roof 103.

After the roof 103 is formed over the carrier 101, as shown in Fig. 4, a circuit pattern 104 may be formed on the roof 103. Without limitation, the circuit pattern 104 may include an inductor.

As shown in Fig. 5, a second material layer may be formed over the surface of the carrier 101, the second material layer covers the roof 103 and then patterned to form the support wall 105.

As a non-limiting example, suitable materials for the second material layer may include photoresist materials, such as PI, BCB and other polymers. Such a photoresist material may be provided either in the form of a dry film, or as a liquid, which may be coated on the carrier 101 and then cured into the second material layer.

In the case of the second material layer being a photoresist material, as an example, the performing a patterning treatment on of the second material layer may involve an exposure and development process thereon. This allows the support wall 105 to be formed using a simple process not involving etching that may potentially cause damage to the roof 103. In an alternative embodiment, after the second material layer is formed, a patterned mask layer may be formed thereon, and the second material layer may be then etched while being protected by the patterned mask layer, thereby obtaining the support wall 105.

In the present embodiment, the support wall 105 is made of the same material as the roof 103. This can avoid a significant coefficient of thermal expansion (CTE) difference between the two, which may otherwise occur if they are made of different materials, thereby contributing to increased reliability of the product being fabricated.

Referring to Fig. 5, the support wall 105 encircles the circuit pattern 104, and the support wall 105 may have a thickness greater than that of the circuit pattern 104. For example, the support wall 105 may be an annular wall surrounding the circuit pattern 104. With this arrangement, the circuit pattern 104 is situated within a recess defined by the roof 103 and the support wall 105. This contributes to enhanced protection for the circuit pattern 104.

Referring to Fig. 5, outer edges of the support wall 105 may be aligned with edges of the roof 103, without limitation.

In step S2, as shown in Fig. 6, a substrate 201 formed with a resonant structure on a surface thereof is provided. The resonant structure includes a resonance body 202 and electrodes 203 on opposite sides of the resonance body 202, each having a first portion adjacent to the resonance body 202 and a second portion away from the resonance body 202.

In the present embodiment, the resonance body 202 may be an interdigital transducer (IDT). In the case of the resonance body 202 being implemented as an IDT, as an example, the prevision of the substrate 201 formed with the resonant structure on its surface may include: providing the substrate 201; forming a metallic material layer on the surface of the substrate 201; and performing a patterning treatment on the metallic material layer to form the IDT and the electrodes 203 on the surface of the substrate 201.

In the present embodiment, the IDT and electrodes 203 are formed in a single process and may have equal thicknesses. In alternative embodiments, if required, the IDT and the electrodes 203 may be formed in separate processes, and/or may have different thicknesses.

For example, the electrodes 203 and the IDT may be made of copper, nickel-palladium-gold, nickel-gold, aluminum or another metallic material. Without limitation, the electrodes 203 and the IDT may have a thickness of 1 µm to 5 µm.

The substrate 201 may be a piezoelectric substrate. Suitable materials for the piezoelectric substrate may include aluminum nitride (AlN), quartz, lithium niobate and lithium tantalite.

Referring to Fig. 6, a plurality of resonance bodies 202 may be formed on the substrate 201, each provided with electrodes 203 formed on the opposite sides of the resonance body 202.

It should be noted that although step S1 precedes step S2 in the present embodiment, the present invention is not so limited. In alternative embodiments, step S2 may precede step S1, or the two steps may occur in parallel.

In step S3, referring to Fig. 7, the carrier 101 with the roof structure formed on its surface and the substrate 201 with the resonant structure formed on its surface are bonded together while being oriented so that the surface of the carrier 101 with the roof structure and the surface of the substrate 201 with the resonant structure face each other. As a result, the support wall 105 is bonded to the first portions of the electrodes 203, and the substrate 201, the support wall 105 and the roof 103 together enclose a cavity 301 necessary for operation of the resonance body 202, which is now situated within the recess defined by the roof 103 and the support wall 105.

In the present embodiment, the bonding of the carrier 101 and the substrate 201 relies on the bonding of the support wall 105 and the electrodes 203, which occurs at an end face of the support wall 105 and the first portions of the electrodes 203, with the second portions 203a of the electrodes being reserved.

In the present embodiment, the bonding of the carrier 101 and the substrate 201 may be accomplished by hot-press bonding so that the photoresist material in the support wall 105 sticks to surfaces of the electrodes 203. In alternative embodiments, the bonding of the carrier 101 with the roof structure formed on its surface and the substrate 201 with the resonant structure formed on its surface may be accomplished by any other suitable bonding method known in the art.

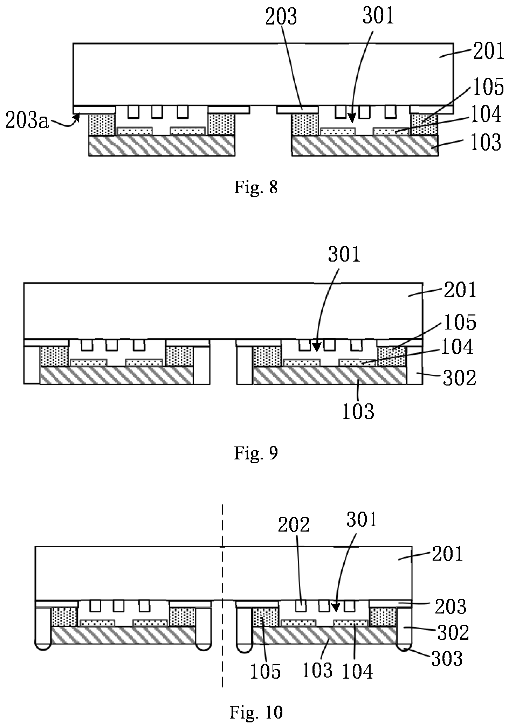

In step S4, referring to Figs. 7 and 8, the carrier 101 and the adhesive layer 102 are removed, exposing the second portions 203a of the electrodes that extend laterally beyond the roof structure.

It should be noted that since the roof 103 is attached to the adhesive layer 102 applied to the surface of the carrier 101, the roof 103 can be easily detached from the carrier 101 during the removal thereof using a simple process without involving etching.

In step S5, as shown in Figs. 9 and 10, conductive structures are formed on the second portions 203a of the electrodes so as to protrude beyond a surface of the roof 103 away from the resonant structure.

Specifically, each conductive structure may include a conductive post 302 and a bump 303. One end of the conductive post 302 is attached to the second portion of the corresponding electrode 203, and the bump 303 resides on the other end of the conductive post 302 and protrudes beyond the surface of the roof 103 away from the resonant structure.

The formation of the conductive structures on the second portions of the electrodes 203 may include: as shown in Fig. 9, forming the conductive posts 302 on the second portions of the electrodes 203, optionally by electroplating or another technique, alongside side walls of the support wall 105 and the roof 103; and as shown in Fig. 10, forming the bumps 303 that protrude beyond the surface of the roof 103 away from the resonant structure on the other ends of the conductive posts 302 away from the electrodes 203.

It should be noted that, in the present embodiment, as shown in Figs. 8 and 9, since the outer edge of the support wall 105 is aligned with the edge of the roof 103, the side walls of the support wall 105 and the roof 103 that define spaces for the formation of the conductive posts together form continuous, straight side walls of the spaces, which allow for good quality of the conductive posts 302 formed on the second portions of the electrodes 203 so as to fill the spaces. This contributes to stable electrical conduction properties of the conductive posts 302.

As a non-limiting example, end faces of the conductive posts 302 away from the electrodes 203 may be flush with the surface of the roof 103 away from the electrodes 203. Suitable materials for the conductive posts 302 may include copper, nickel, tin-silver and other metallic materials. Without limitation, the bumps 303 may be formed on the end faces of the conductive posts 302 away from the electrodes 203 by placement and then reflow soldering of solder balls.

Subsequently, referring to Figs. 10 and 11, in case of a plurality of packaging structures being fabricated, the substrate 201 may be diced, obtaining individual packaged dies.

According to an alternative embodiment disclosed herein, in step S1, before the first material layer 103a is formed on the surface of the carrier 101, an inorganic material layer may be formed on the surface of the carrier 101 and then patterned to form a reinforcement layer 106, as shown in Fig. 12. In this case, the roof 103 may be subsequently formed on the reinforcement layer 106. The reinforcement layer 106 is formed to increase resistance of the roof 103 to pressure, enhancing reliability of the resulting filter packaging structure. The inorganic material layer, from which the reinforcement layer 106 is fabricated, may be a silicon oxide (SiO₂) or silicon nitride (Si₃N₄) layer, for example.

Embodiments of the present invention also provide filter packaging structure obtainable according to the method discussed above. The filter packaging structure may be obtained either as a packaging structure that has not been diced yet, or as an individual packaged die obtained from singulation by dicing.

Referring to Fig. 11, the filter packaging structure includes a substrate 201, a resonant structure, a roof structure and conductive structures. The resonant structure is formed on a surface of the substrate 201, and the resonant structure includes a resonance body 202 and electrodes 203 on opposite sides of the resonance body 202, each having a first portion adjacent to the resonance body 202 and a second portion away from the resonance body 202. The roof structure includes a roof 103 and a support wall 105 on the roof 103. The support wall 105 is bonded to the first portions of the electrodes 203, while the second portions of the electrodes 203 extend laterally beyond the roof structure. The substrate 201, the support wall 105 and the roof 103 together enclose a cavity 301 necessary for operation of the resonance body 202. The conductive structures reside on the second portions of the electrodes 203 and protrude beyond a surface of the roof 103 away from the resonant structure.

As an example, the filter packaging structure of the present embodiment may be a surface acoustic wave (SAW) filter packaging structure. In this case, the resonance body 202 may be an interdigital transducer (IDT), and the electrodes 203 are accordingly located on opposite sides of the IDT. In an alternative embodiment, the filter packaging structure may be another filter, which relies on a cavity to deliver its filtering functionality, such as a bulk acoustic wave (BAW) filter packaging structure.

For example, the electrodes 203 may be made of a metallic material, such as copper, nickel-palladium-gold, nickel-gold, or aluminum, and may have a thickness of 1 µm to 5 µm. Without limitation, the resonance body 202 may be made of the same material, and have the same thickness, as the electrodes 203. Alternatively, the thickness of the resonance body 202 may be different from that of the electrodes 203.

Referring to Fig. 11, the roof structure and the substrate 201 may be bonded together as a result of the bonding of the support wall 105 and the electrodes 203. The support wall 105 may be an annular wall surrounding the resonance body 202.

For example, the support wall 105 and the roof 103 may be both made of a photoresist material. In this case, the support wall 105 and the roof 103 may be obtained using an exposure and development process. This allows high structural accuracy to be obtained using a simple process.

In the present embodiment, the roof structure may be fabricated on the carrier in advance, with the roof 103 being attached to the carrier, and the support wall 105 may be stacked on the roof 103. This circumvents the formation of a cavity by laminating a film onto the support wall, which may suffer from poor flatness, uniformity and adhesion strength of the laminated film, and hence from proneness of the cavity to deformation and of the roof to peeling. Therefore, improved reliability can be obtained.

Referring to Fig. 11, a circuit pattern 104 is formed on a surface of the roof 103 adjacent to the resonance body 202. This circuit pattern 104 may be formed before the roof structure is bonded to the substrate 201. This allows the circuit pattern 104 to be integrated onto the inner surface of the roof 103 adjacent to the cavity 301, increasing the integration density of the filter packaging structure and diversifying the filter's functionality. Moreover, the circuit pattern 104 can be formed more easily, without considering pressure resistance of the cavity 301. Further, the cavity 301 can provide protection for the circuit pattern 104. Suitable materials for the circuit pattern 104 may include copper and aluminum, for example. Without limitation, the circuit pattern 104 may include an inductor.

For example, each conductive structure may include a conductive post 302 and a bump 303. One end of the conductive post 302 is attached to the second portion of the corresponding electrode 203, and the bump 303 resides on the other end of the conductive post 302 away from the electrode 203 and protrudes beyond the surface of the roof 103 away from the resonant structure. Suitable materials for the conductive posts 302 may include copper, nickel, tin-silver and other metallic materials. Without limitation, the bumps 303 may be made of tin.

According to an alternative embodiment disclosed herein, as shown in Fig. 12, the roof structure may further include a reinforcement layer 106 attached to the surface of the roof 103 away from resonant structure. The reinforcement layer 106 is included to increase resistance of the roof 103 to pressure, enhancing reliability of the filter packaging structure. As an example, the reinforcement layer 106 may be made from an inorganic material layer, such as a silicon oxide (SO₂) or silicon nitride (Si₃N₄) layer.

The present invention provides a filter packaging structure and a method of manufacturing the structure, in which a roof structure may be fabricated on a carrier in advance and bonded to a substrate 201 formed with a resonant structure on its surface by bonding a support wall 105 therein to electrodes 203 in the resonant structure, resulting in the formation of a cavity necessary for operation of a resonance body 202. This circumvents the formation of a cavity by laminating a film onto the support wall, which may suffer from poor flatness, uniformity and adhesion strength of the laminated film, and hence from proneness of the cavity to deformation and of the roof to peeling, improving reliability of the filter packaging structure. Moreover, compared with forming a cavity using a cap wafer, this entails a low-cost process with reduced control complexity and allows the resulting packaging structure to have a smaller thickness. According to the present invention, the support wall 105 is bonded to first portions of the electrodes 203, with second portions thereof extending laterally beyond the roof structure being reserved. Thus, after the roof structure is bonded to the substrate 201, conductive structures can be directly formed on the second portions of the electrodes 203 without perforation, entailing a simple process. Moreover, compared with forming solder pads and bumps on the roof, directly forming the conductive structures on the second portions of the electrodes 203 enables easier control of a height of the conductive structures protruding beyond the roof, contributing to a reduced thickness of the resulting filter packaging structure.

It should be noted that the embodiments disclosed herein are described in a progressive manner, with the description of each embodiment focusing on its differences from others. Cross-reference is made between the embodiments for their common or similar features.

While the invention has been described above with reference to several preferred embodiments, it is not intended to be limited to these embodiments in any way. In light of the teachings hereinabove, any person of skill in the art may make various possible variations and changes to the disclosed embodiments without departing from the spirit or scope of the invention. Accordingly, any and all such simple variations, equivalent alternatives and modifications made to the foregoing embodiments without departing from the scope of the invention are intended to fall within the scope thereof.

## Claims

1. A manufacturing method for a filter packaging structure, comprising:
providing a carrier having a roof structure formed on a surface thereof, the roof structure comprising a roof attached to the surface of the carrier and a support wall on the roof;
providing a substrate having a resonant structure formed on a surface thereof, the resonant structure comprising a resonance body and electrodes on opposite sides of the resonance body, each having a first portion adjacent to the resonance body and a second portion away from the resonance body;
bonding the carrier formed with the roof structure on its surface and the substrate formed with the resonant structure on its surface to each other so that the support wall is bonded to the first portions of the electrodes and that the substrate, the support wall and the roof together enclose a cavity necessary for an operation of the resonance body;
removing the carrier, thereby exposing the second portions of the electrodes that extend laterally beyond the roof structure; and
forming conductive structures on the second portions of the electrodes, which protrude beyond a surface of the roof away from the resonant structure.

2. The manufacturing method for the filter packaging structure of claim 1, wherein providing the carrier formed with the roof structure on its surface comprises:
providing the carrier;
forming a first material layer over the surface of the carrier;
performing a patterning treatment on the first material layer to form the roof;
forming a second material layer over the surface of the carrier, which covers the roof; and
performing a patterning treatment on the second material layer to form the support wall.

3. The manufacturing method for the filter packaging structure of claim 2, wherein each of the roof and the support wall is made of a material comprising a photoresist material, and wherein the performing a patterning treatment on of the first material layer and the performing a patterning treatment on of the second material layer each comprise an exposure and development process.

4. The manufacturing method for the filter packaging structure of claim 2, wherein after the first material layer is patterned to form the roof and before the second material layer is formed over the surface of the carrier, a circuit pattern is formed on the roof.

5. The manufacturing method for the filter packaging structure of claim 2, wherein before the first material layer is formed over the surface of the carrier, an inorganic material layer is formed on the surface of the carrier and patterned to form a reinforcement layer, and wherein the roof resides on the reinforcement layer.

6. The manufacturing method for the filter packaging structure of claim 1, wherein the resonance body is an interdigital transducer (IDT), wherein providing the substrate formed with the resonant structure on its surface comprises:
providing the substrate;
forming a metallic material layer on the surface of the substrate; and
performing a patterning treatment on the metallic material layer to form the IDT and the electrodes that are attached to the surface of the substrate.

7. The manufacturing method for the filter packaging structure of claim 1, wherein forming the conductive structures on the second portions of the electrodes comprises:
forming conductive posts on the second portions of the electrodes; and
forming bumps at ends of the conductive posts away from the electrodes, which extend beyond the surface of the roof away from the resonant structure.

8. The manufacturing method for the filter packaging structure of claim 2, wherein the first material layer is patterned to form a plurality of roofs on the carrier.

9. The manufacturing method for the filter packaging structure of claim 4, wherein the support wall is an annular wall, the annular wall surrounding the circuit pattern, and wherein the circuit pattern is situated within a recess defined by the roof and the support wall.

10. The manufacturing method for the filter packaging structure of claim 6, wherein the IDT and the electrodes are formed in a single process, and wherein the IDT and the electrodes have equal thicknesses.

11. A filter packaging structure, comprising a substrate, a resonant structure, a roof structure and conductive structures,
the resonant structure formed on a surface of the substrate and comprising a resonance body and electrodes on opposite sides of the resonance body, each having a first portion adjacent to the resonance body and a second portion away from the resonance body,
the roof structure comprising a roof and a support wall on the roof, the support wall bonded to the first portions of the electrodes, with the second portions of the electrodes extending laterally beyond the roof structure, the support wall and the roof enclosing, together with the substrate, a cavity necessary for an operation of the resonance body,
the conductive structures arranged on the second portions of the respective electrodes and protruding beyond a surface of the roof away from the resonant structure.

12. The filter packaging structure of claim 11, wherein the resonance body is an interdigital transducer (IDT), and wherein the electrodes are located on opposite sides of the IDT.

13. The filter packaging structure of claim 11, wherein the support wall surrounds the resonance body.

14. The filter packaging structure of claim 11, wherein the roof is formed with a circuit pattern on its surface adjacent to the resonance body.

15. The filter packaging structure of claim 11, wherein the roof structure further comprises a reinforcement layer, the reinforcement layer being attached to the surface of the roof away from the resonant structure.

16. The filter packaging structure of claim 11, wherein each of the conductive structures comprises a conductive post and a bump, one end of the conductive post attached to the second portion of a respective one of the electrodes, the bump provided at the other end of the conductive post away from the respective electrode, and the bump protruding beyond the surface of the roof away from the resonant structure.

17. The filter packaging structure of claim 11, wherein each of the support wall and the roof is made of a photoresist material.

18. The filter packaging structure of claim 11, wherein a plurality of roofs are formed on the carrier.

19. The filter packaging structure of claim 14, wherein the support wall is an annular wall, the annular wall being surrounding the circuit pattern, and wherein the circuit pattern is situated within a recess defined by the roof and the support wall.

20. The filter packaging structure of claim 12, wherein the IDT has the same thickness as the electrodes.
